# EUROPÄISCHE PATENTANMELDUNG

(11) **EP 2 309 518 A2**
(43) Veröffentlichungstag der Anmeldung: **13.04.2011**
(21) Anmeldenummer: 10186428.8
(22) Anmeldetag: 04.10.2010
(51) Int. Cl.: G21K 4/00

(54) **Verfahren zur Herstellung eines Szintillationsmaterials mit geringer Spannungsdoppelbrechung und hoher Homogenität der Brechzahl**

(30) Priorität: 09.10.2009 DE 102009045520
(71) Anmelder: Schott AG, 55122 Mainz (DE)
(72) Erfinder: von Saldern, Johann-Christoph, 07743, Jena (DE); Seitz, Christoph, 07745, Jena (DE); Parthier, Lutz, 14532, Kleinmachnowg (DE); Alkemper, Jochen, 55270, Klein-Winternheim (DE)
(74) Vertreter: Fuchs

(57) **Zusammenfassung**

Die vorliegende Erfindung betrifft ein Verfahren zur Herstellung von Szintillationsmaterialien, die ein geringe Spannungsdoppelbrechung und hohe Homogenität der Brechzahl aufweisen. Die Szintillationsmaterialien basieren beispielsweise auf Lanthanhalogeniden, dotiert oder undotiert. Sie weisen hervorragende Detektionseigenschaften auf. Die Materialien können einkristallin und polykristallin vorliegen. Sofern es sich um kristalline Materialien handelt, sind diese in vorzugsweisen Größen mit bis zu 5 cm³ herstellbar.

## Beschreibung

Die vorliegende Erfindung betrifft ein verbessertes Verfahren zur Herstellung von Szintillationsmaterialien. Das verfahrensgemäß erhaltene Szintillationsmaterial weist vorteilhafte Eigenschaften auf. Dies sind geringe Spannungsdoppelbrechung (SDB) und eine hohe Homogenität der Brechzahl (HOM). Dadurch können Detektoreigenschaften verbessert werden. Ferner weisen die erfindungsgemäß hergestellten Materialien eine hohe mechanische Stabilität auf, insbesondere wenn diese dotiert sind, was eine besondere Ausführungsform der Erfindung darstellt.

Szintillationsmaterialien gemäß dem Stand der Technik weisen häufig eine signifikante Spannungsdoppelbrechung auf, was zu schlechten Detektoreigenschaften führt. Ferner verhält sich die Brechzahl im Material nicht homogen, was zu ungünstigen Lichtausbeuten führt. Diese problematischen Eigenschaften von Szintillationsmaterialien, die aus dem Stand der Technik bekannt sind, ergeben sich auch aus deren Herstellungsverfahren.

Solche Herstellungsverfahren sind darüber hinaus nachteilig, da diese zu geringen Ausbeuten führen. Schließlich gibt es neben den hohen Anforderungen an die Spannungsdoppelbrechung und die Homogenität der Brechzahl auch noch andere Parameter, die von Szintillationsmaterialien erfüllt werden sollten. Dazu gehört beispielsweise die Bruchempfindlichkeit. Gemäß den Herstellungsverfahren, die derzeit bekannt sind, werden Szintillationsmaterialien erhalten, die bruchempfindlich sind, was im Wesentlichen durch Inhomogenitäten im Material, durch thermische Verspannungen und auch durch Kristalldefekte hervorgerufen wird.

Die mechanische Belastbarkeit solcher bekannten Materialien mit Blick auf Trennen, Schleifen und Polieren, ist hierdurch stark eingeschränkt, bzw. der hierfür benötigte Aufwand wird erhöht. Wie schon erwähnt, sind die Ausbeuten gering, so dass die Verfahren mit erheblichem Ausschuss belastet sind.

Die für Materialien aus dem Stand der Technik als ungünstig bekannte erhebliche Spannungsdoppelbrechung sowie die Inhomogenitäten mit Blick auf die Brechzahl sind Mängel, die ursächlich für teilweise erhebliche Unterschiede des Szintillationseigenschaften und mechanischen Eigenschaften von Kristall zu Kristall sind.

Das Verfahren gemäß der vorliegenden Erfindung beschränkt sich jedoch nicht auf die Herstellung einkristalliner Szintillationsmaterialien, wenngleich dies eine besondere Ausführungsform darstellt. Vielmehr können erfindungsgemäß auch polykristalline Materialien hergestellt werden. Solche polykristallinen Gebilde sind bevorzugter weise im Wesentlichen ohne Zwischenräume/Korngrenzen, was annähernd zu Eigenschaften führt, die einem Einkristall entsprechen.

Bevorzugt sind Verfahren zur Herstellung einkristalliner Szintillationsmaterialien, da die erfindungsgemäßen Verfahren geeignet sind, Einkristalle in vorzugsweiser Größe herzustellen. Sofern das Material polykristallin ist, sollten die einzelnen Kristallite dergestalt ausgebildet sein, dass diese in einer Art und Weise angeordnet sind, die ein möglichst isotropes Verhalten des jeweiligen Materials bedingen kann (siehe Ausführung oben).

Aus dem Stand der Technik sind beispielsweise Szintillationsmaterialien auf der Basis von Cerbromid bekannt, siehe beispielsweise US 7,405,404 B1. Das hier diskutierte Cerbromid kann auch dotiert sein. Insbesondere Yttrium, Hafnium, Palladium, Zirkon und Bismut sind als Dotanden nicht erwähnt. Ferner sind die Verfahren zur Herstellung der einkristallinen Szintillationsmaterialien gängige, dem Fachmann bekannte Verfahren. Besondere Abkühlbedingungen oder Abkühlraten während des Herstellungsverfahrens werden nicht erwähnt.

EP 1 930 395 A2 beschreibt Szintillatorzusammensetzungen, die aus unterschiedlichen "Vor-Szintillatorzusammensetzungen" hergestellt werden. Temperregime oder Abkühlraten werden hierbei nicht diskutiert.

US 2008/0067391 A1 offenbart unter Anderem einkristalline Szintillatoren einer bestimmten Formel. Es geht hierbei um Dotanden in dem Material und nicht um ein bestimmtes Herstellungsverfahren, dass eine bevorzugte Spannungsdoppelbrechung bedingen könnte. Gleiches gilt für US 2008/0011953 A1.

Es besteht demnach ein großer Bedarf an einem neuen Herstellungsverfahren für Szintillationsmaterialien, die eine geringe Spannungsdoppelbrechung und eine hohe Homogenität der Brechzahl aufweisen. Dabei soll das Verfahren insofern flexibel einsetzbar sein, als sowohl einkristalline als auch polykristalline Szintillationsmaterialien damit herstellbar sind.

Sofern das Szintillationsmaterial einkristallin vorliegt, soll ein Verfahren bereitgestellt werden, das möglichst große Einkristalle hervorbringt.

Die Verfahren sollen ferner möglichst Materialien in hoher Ausbeute und auf einfache Art und Weise herstellen können.

Vorzugsweise weisen die nach dem erfindungsgemäßen Verfahren hergestellten Materialien nicht nur die schon weiter oben beschriebenen vorteilhaften Eigenschaften auf, sondern sind ferner noch mit Blick auf mechanische Eigenschaften erheblich verbessert.

Das erfindungsgemäße Verfahren soll auch insofern flexibel einsetzbar sein, als auch dotierte Lanthanhalogenide damit hergestellt werden können.

Gelöst werden die Aufgaben der vorliegenden Erfindung durch Verfahren, wie in den Patentansprüchen beschrieben.

Die Erfindung betrifft insbesondere ein

Verfahren zur Herstellung eines Szintillationsmaterials, umfassend eine Verbindung der allgemeinen Summenformel LnX₃ oder LnX₃:D, wobei Ln ausgewählt ist aus mindestens einem von Sc, Y, La, Ce, Pr, Nd, Pm, Sm, Eu, Gd, Tb, Dy, Ho, Er, Tm, Yb, Lu und X ausgewählt ist aus F, Cl, Br und I, und D ein kationischer Dotand, ausgewählt aus einem oder mehreren der Elemente Y, Zr, Pd, Hf und Bi ist und in einer Menge von 10 ppm bis 10.000 ppm im Material vorliegt, umfassend
wahlweise Mischen von LnX₃ mit mindestens einem der Dotanden D, Erwärmen bis zum Schmelzpunkt der Substanz oder des Gemisches, Züchten des Kristalls oder des kristallinen Gefüges, **dadurch gekennzeichnet, dass** der Kristalls oder das kristalline Gefüge von der Züchtungstemperatur bis zu einer Temperatur von 100°C mit einer Abkühlrate von kleiner als 20K/h abgekühlt wird.

Gemäß einer Ausführungsform umfasst das Verfahren weiterhin die folgenden Schritte:
- Einbringen eines Lanthanhalogenids, wahlweise mit oder ohne Dotand, in eine geeignete Ampulle;
- Evakuierung der Ampulle;
- Wahlweise Abschmelzen der Ampulle;
- Erwärmen der Ampulle und anschließendes Züchten eines Kristalls oder eines kristallinen Gefüges,
- Abkühlen des Kristalls oder das kristallinen Gefüges von der Züchtungstemperatur bis zu einer Temperatur von 100°C mit einer Abkühlrate von kleiner als 20K/h,
- Abkühlen des Kristalls oder das kristallinen Gefüges von 100°C bis 25°C mit einer Abkühlrate von weniger als 40 K/h.

Vorzugsweise beträgt der maximale Temperaturgradient im Kristall, sofern es sich um einkristallines Material handelt, zu jedem Zeitpunkt der Züchtung weniger als 10K/cm. Gemäß besonders bevorzugten Ausführungsformen ist dieser Temperaturgradient weniger als 5K/cm und am meisten bevorzugt weniger als 2K/cm.

Die Abkühlrate innerhalb des Temperaturbereiches, der von der Züchtungstemperatur aus bis etwa 100°C reicht, ist gemäß bevorzugten Ausführungsformen des erfindungsgemäßen Verfahrens unterhalb 10K/h und am meisten bevorzugt etwa 5K/h.

Was die weitere Abkühlrate in dem Temperaturbereich ausgehend von etwa 100°C bis 25°C betrifft, so ist gemäß dem erfindungsgemäßen Verfahren die Abkühlrate 20K/h und weiter bevorzugt 10K/h.

Das erfindungsgemäße Verfahren ist universell einsetzbar zur Herstellung von Szintillationsmaterialien der Formel LnX₃, wobei Ln ausgewählt ist aus Sc, Y, La, Ce, Pr, Nd, Pm, Sm, Eu, Gd, Tb, Dy, Ho, Er, Tm, Yb, Lu und X ausgewählt aus F, Cl, Br und I. Ebenso herstellbar sind Materialien der Formel LnX₃:D, wobei für Ln und X die zuvor genannten Definitionen gelten und D ein kationischer Dotand, ausgewählt aus einem oder mehreren der Elemente Y, Zr, Hf, Pd und Bi ist, und in einer Menge von 10 ppm bis 10.000 ppm im Material vorliegt. Vorzugsweise werden erfindungsgemäß Szintillationsmaterialien hergestellt, die aus der zuvor genannten Verbindung LnX₃ oder LnX₃:D besteht.

Sofern aus dem erfindungsgemäßen Verfahren Materialien hervorgehen, die dotiert sind, kann der Dotand in einer Menge von 10 ppm bis 10.000 ppm, wahlweise bis 5.000 ppm im Material vorliegen, vorzugsweise in einer Menge von 50 ppm bis 1.000 ppm und weiter bevorzugt von 100 ppm bis 1.000 ppm.

Erfindungsgemäß bevorzugt wird reines Cerbromid gemäß dem hier beschriebenen Verfahren hergestellt. Ferner bevorzugt sind auch Materialien, für die das Kation Lanthan, Lutetium und Praseodym ist. Bevorzugte Anionen sind Chlor, Brom und lod, mit Chlor und Brom als weiter bevorzugte Anionen.

Die erfindungsgemäßen Abkühlraten können umgesetzt werden gemäß dem Fachmann an sich bekannten Verfahren zur Herstellung von Einkristallen, wie beispielsweise das Bridgman oder Czochralski-Verfahren. In üblicher Weise werden Ausgangshalogenide, mit oder ohne Dotanden, zur Schmelze erwärmt und dann erfindungsgemäß zur Kristallisation abgekühlt.

Die erfindungsgemäß erhaltenen Materialien zeichnen sich unter anderem durch eine exzellente Lichtausbeute aus. Die Abklingzeit der Szintillationsmaterialien verkürzt sich.

Für den Fall einkristalliner Materialien ist es möglich, großvolumige Einheiten mit größer als 5 cm³ herzustellen, die die erfindungsgemäß gewünschten niedrigen Spannungsdoppelbrechungen und hervorragenden Homogenitäten der Brechzahl aufweisen.

Sofern die Materialien dotiert sind, liegt der Dotand oder liegen die Dotanden in Mengen von 50 ppm bis 5.000 ppm, weiter bevorzugt in Mengen von 100 ppm bis 1.000 ppm in Szintillationsmaterial vor.

Aufgrund des unterschiedlichen lonenradius der Dotanden D zu den Kationen der Gruppe Ln werden lokale Spannungen im Wirtskristall hervorgerufen. Bislang wurde angenommen, dass solche lokalen Spannungen nachteilig sind. Überraschenderweise konnte jedoch nun gefunden werden, dass diese die Gitterenergie erhöhen und zwar in dem Maße, dass die kritische Energie zur Rissbildung bzw. zur Fortschreitung von Rissen deutliche erhöht wird.

Beim Züchtungsprozess führen diese lokalen Spannungen zu weniger Kristallbaufehlern. Die durch den zur Zucht nötigen Gradienten erzeugten thermischen Spannungen werden nicht durch Defekte abgebaut (kein plastischer sondern elastischer Spannungsabbau). Dies führt zum einen zu einer geringeren thermischen Verspannung des Kristalls durch den erfindungsgemäßen Abkühlprozess.

Ferner führt die geringere Defektkonzentration zu einer Verringerung der nicht strahlenden Übergänge und damit zu einer Erhöhung der Lichtausbeute, des Light Yields, insbesondere ohne dabei die anderen Szintillationseigenschaften, wie die Abklingzeit und die Energieauflösung, negativ zu beeinflussen. Es kann ein Dotand D in einer Menge von 500 ppm bis 5.000 ppm im erfindungsgemäß hergestellten Szintillationsmaterial vorliegen. Besonders bevorzugt ist ein Gehalt von 100 ppm, bevorzugt größer als 500 ppm bis zur Obergrenze von 1.000 ppm.

Es hat sich herausgestellt, dass das erfindungsgemäß hergestellte Szintillationsmaterial besonders vorteilhafte Eigenschaften aufweist wenn das Element Ln, das kationisch vorliegt, ausgewählt ist aus La, Ce, Lu, Pr und Eu. Vorzugsweise ist Ln ausgewählt aus La und Ce.

Das Anion X ist besonders bevorzugt ausgewählt aus Cl, Br und I, weiter bevorzugt ausgewählt aus Cl und Br. Am meisten bevorzugt ist das erfindungsgemäße Szintillationsmaterial dotiertes CeBr₃.

Auch bevorzugt gemäß der vorliegenden Erfindung wird dotiertes Lutetiumiodid und ebenso dotiertes Lanthanbromid hergestellt.

Szintillationsmaterialien der oben beschriebenen Zusammensetzungen mit den erfindungsgemäßen Dotanden hergestellt nach der Erfindung zeichnen sich durch eine ausgesprochene Härte auch bei Temperaturen nahe ihrem Schmelzpunkt aus. In der Folge werden weniger Kristalldefekte erzeugt und weniger Spannungen generiert.

Bei der Durchführung des erfindungsgemäßen Verfahrens wird beim Tempern ein homogenes Temperaturfeld mit einer Temperatur von maximal 10 K, bevorzugt 50 K und am meisten 100 K unterhalb der Schmelztemperatur des Materials. Der Temperaturgradient ist dabei kleiner 2 K/cm, bevorzugt kleiner 1 K/cm und am meisten bevorzugt kleiner 0,5 K/cm. Die Aufheiz- und Abkühlraten sind im Temperschritt wie beim Abkühlprozess zu wählen.

Das so erhaltene Szintillationsmaterial zeichnet sich durch eine Spannungsdoppelbrechung von kleiner als 1 µm/cm, bevorzugt kleiner 50 nm/cm und am meisten kleiner 10 nm/cm aus. Neben der Spannungsdoppelbrechung wird durch eine geeignete Temperung auch die Brechzahlhomogenität deutlich verbessert. Damit sind PV-Werte von besser als Δn =10⁻³ zu erzielen. Unter dem PV-Wert versteht der Fachmann den maximal auftretenden Unterschied der Brechzahlen. PV steht als Abkürzung für "**p**eak to **v**alley".

Erfindungsgemäß beträgt die Hintergrundstrahlung des Szintillationsmaterials weniger als 0,5 Bq/cm³, was durch die hohe Reinheit des Materials ermöglicht wird. Verunreinigungen, die zu radioaktiver Hintergrundstrahlung beitragen, werden durch die Wahl entsprechend reiner Ausgangsverbindungen vermieden.

Die folgenden Beispiele dienen der Erörterung der Erfindung und sind nicht einschränkend.

### Beispiel 1

Zur Herstellung eines erfindungsgemäßen Materials werden in eine Ampulle aus Quarzglas mit einem Innendurchmesser von 30 mm in einer mit Argon gefüllten "Glovebox", wobei Wasser und Sauerstoff zu weniger als 5 ppm in der Atmosphäre vorliegen, 500 g Cerbromid eingewogen. Die Ampulle wurde anschließend evakuiert und mit 50 mbar Argon befüllt und abgeschmolzen. An der Spitze der Ampulle befindet sich eine 30 mm lange Kapillare mit einem Innendurchmesser von 3 mm. Die Ampulle wurde in einen 3 Zonen Bridgman Ofen verbracht. Zunächst wurde die Temperatur 48 Stunden lang bei 780°C gehalten. Anschließend wurde mit einer Absenkrate von 1 mm/h ein Kristall gezüchtet. Der Kristall wird sodann abgekühlt. Von der Züchtungstemperatur bis zu einer Temperatur von 100°C mit einer Abkühlrate von kleiner als 10K/h. Danach wird die Abkühlrate auf kleiner 20K/h bis zum Erreichen der Raumtemperatur justiert. Während der gesamten Zucht war der Temperaturgradient im Kristall kleiner als 5K/cm.

Die Ampulle wurde dann in der Glovebox geöffnet und der Kristall entnommen.

### Beispiel 2

Zur Herstellung eines erfindungsgemäßen Materials werden in eine Ampulle aus Quarzglas mit einem Innendurchmesser von 30 mm in einer mit Argon gefüllte "Glovebox", wobei Wasser und Sauerstoff zu weniger als 5 ppm in der Atmosphäre vorliegen, 500 g Cerbromid, 0,26 g BiBr₃ (entsprechend 0,125 g Bismut) und 0,29 g HfBr₃ (entsprechend 0,125 g Hafnium) eingewogen. Die Ampulle wurde anschließend evakuiert und mit 50 mbar Argon befüllt und abgeschmolzen. An der Spitze der Ampulle befindet sich eine 30 mm lange Kapillare mit einem Innendurchmesser von 3 mm. Die Ampulle wurde in einen 3 Zonen Bridgman Ofen verbracht. Zunächst wurde die Temperatur 48 Stunden lang bei 780°C gehalten. Anschließend wurde mit einer Absenkrate von 1 mm/h ein Kristall gezüchtet. Der Kristall wird sodann abgekühlt. Von der Züchtungstemperatur bis zu einer Temperatur von 100°C mit einer Abkühlrate von kleiner als 10K/h. Danach wird die Abkühlrate auf kleiner 20K/h bis zum Erreichen der Raumtemperatur justiert. Während der gesamten Zucht war der Temperaturgradient im Kristall kleiner als 5K/cm.

Die Ampulle wurde dann in der Glovebox geöffnet und der Kristall entnommen.

## Patentansprüche

1. Verfahren zur Herstellung eines Szintillationsmaterials, umfassend eine Verbindung der allgemeinen Summenformel LnX₃ oder LnX₃:D, wobei Ln ausgewählt ist aus mindestens einem von Sc, Y, La, Ce, Pr, Nd, Pm, Sm, Eu, Gd, Tb, Dy, Ho, Er, Tm, Yb, Lu und X ausgewählt ist aus F, Cl, Br und I, und D ein kationischer Dotand, ausgewählt aus einem oder mehreren der Elemente Y, Zr, Pd, Hf und Bi ist und in einer Menge von 10 ppm bis 10.000 ppm im Material vorliegt, umfassend
wahlweise Mischen von LnX₃ mit mindestens einem der Dotanden D, Erwärmen bis zum Schmelzpunkt der Substanz oder des Gemisches, Züchten des Kristalls oder des kristallinen Gefüges, **dadurch gekennzeichnet, dass**
der Kristalls oder das kristallinen Gefüges von der Züchtungstemperatur bis zu einer Temperatur von 100°C mit einer Abkühlrate von kleiner als 20K/h abgekühlt wird.

2. Verfahren nach Anspruch 1, wobei die Abkühlrate im Bereich der Züchtungstemperatur bis 100°C 10K/h und kleiner beträgt.

3. Verfahren nach Anspruch 1 und/oder 2, wobei die Abkühlrate im Bereich der Züchtungstemperatur bis 100°C 5K/h oder weniger beträgt.

4. Verfahren nach einem oder mehreren der vorhergehenden Ansprüche, wobei ferner der Kristall oder das kristalline Gefüge im Temperaturbereich von 100°C bis 25°C mit einer Abkühlrate von weniger als 40K/h abgekühlt wird.

5. Verfahren nach einem oder mehreren der vorhergehenden Ansprüche, wobei die Abkühlrate im Temperaturbereich von 100°C bis 25°C 20K/h oder weniger beträgt.

6. Verfahren nach einem oder mehreren der vorhergehenden Ansprüche, wobei die Abkühlrate im Temperaturbereich von 100°C bis 25°C 10K/h oder weniger beträgt.

7. Verfahren nach einem oder mehreren der vorhergehenden Ansprüche, wobei der Temperaturgradient im Kristall oder im kristallinen Gefüge kleiner 10K/cm beträgt.

8. Verfahren nach einem oder mehreren der vorhergehenden Ansprüche, wobei beim Tempern ein homogenes Temperaturfeld angewendet wird.

9. Verfahren nach einem oder mehreren der vorhergehenden Ansprüche, wobei beim Tempern ein homogenes Temperaturfeld mit einer Temperatur von maximal 10K unterhalb der Schmelztemperatur des Materials angewendet wird.

10. Verfahren nach einem oder mehreren der vorhergehenden Ansprüche, wobei die Aufheiz- und Abkühlraten im Temperschritt wie beim Abkühlprozess zu wählen sind.
